# EUROPEAN PATENT APPLICATION

(11) **EP 1 207 563 A2**
(43) Date of publication of application: **22.05.2002**
(21) Application number: 01204132.3
(22) Date of filing: 29.10.2001
(51) Int. Cl.: H01L 33/00, H05B 33/08

(54) **Direct bonding of flip-chip light-emitting diode and flip-chip ESD protection chip to electrodes in a package**

(30) Priority: 08.11.2000 US 709150
(71) Applicant: LumiLeds Lighting U.S., LLC, San Jose, California 95131 (US)
(72) Inventor: Maranowski, Steven A., 5656 AA Eindhoven (NL); Steigerwald, Daniel A., 5656 AA Eindhoven (NL)
(74) Representative: Dusseldorp, Jan Charles

(57) **Abstract**

A light-emitting diode (LED) assembly incorporates a power shunting device that prevents damage to an LED due to electrostatic discharge (ESD). The power shunting device protects the LED by diverting electrical current from the LED and limiting the voltage across the LED to a certain voltage. In one embodiment, the LED and power shunting devices are flip-chips having terminals directly bonded to both the positive and negative electrodes, thus enhancing the reliability and ease of construction of the light-emitting diode assembly. A lens encapsulates the LED and optionally encapsulates the power shunting element.

## Description

This invention relates to light-emitting diodes and, in particular, to electrostatic discharge protection for such light-emitting diodes.

Due to their compact size, high reliability and low power consumption, light-emitting diodes (LEDs) have replaced incandescent bulbs in a variety of applications. However, LEDs are susceptible to damage from electrostatic discharge (ESD), which degrades the performance and reliability of the LED.

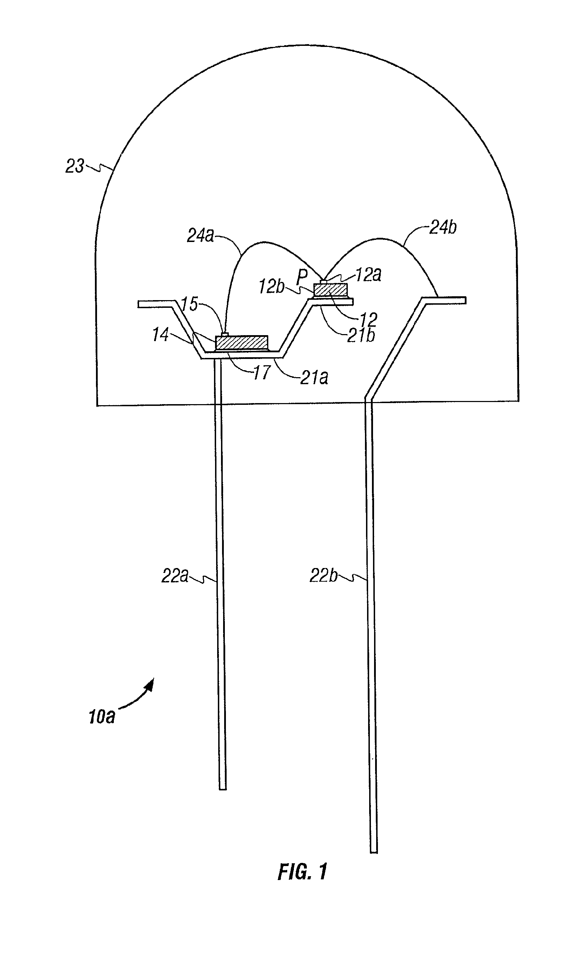

Past attempts to solve these problems have included the incorporation of a power shunting element in the LED package that provides the LED with protection from overvoltages, such as ESD voltages. The power shunting element and LED terminals are coupled in parallel within the LED package. The power shunting element diverts electrical current from the LED to limit voltage across the LED when a certain voltage across the LED is exceeded. An LED assembly incorporating a power shunting element is described in U.S. Patent No. 5,914,501 (the '501 patent) to Hewlett-Packard Company, and that assembly is reproduced in Figure 1. The assembly 10a employs a wire 24a to electrically connect one terminal 15 of the LED 14 to a terminal 12a of the power shunting element 12 and employs another wire 24b to electrically connect the terminal 12a to the positive electrode 22b. The other terminal 17 of the LED 14 and the other terminal 12b of the power shunting element 12 are directly bonded to the negative electrode 22a. A lens 23 encapsulates the assembly.

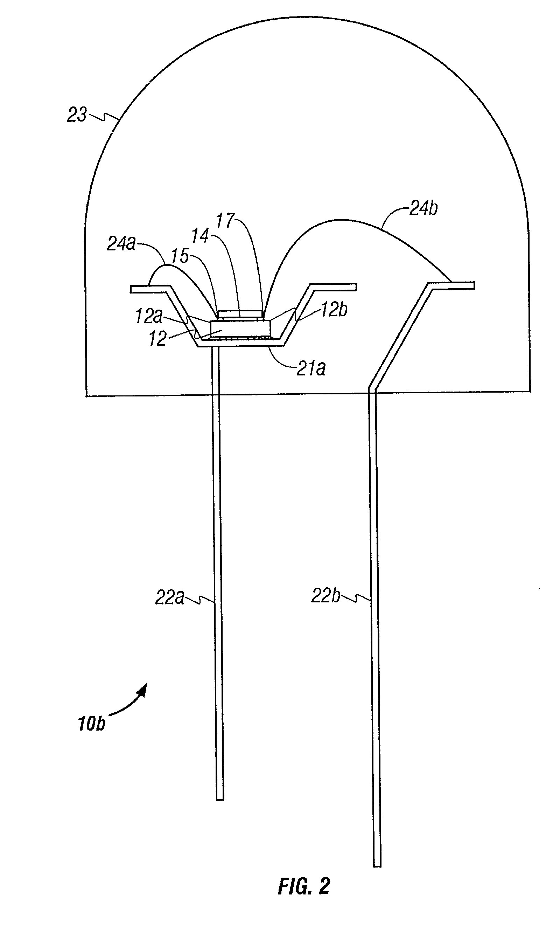

Another LED assembly 10b (Fig. 2) described in the '501 patent incorporates a power shunting element 12 as a submount for the LED 14. The assembly employs wires 24a and 24b to electrically connect the terminals of the LED 14 and power shunting element 12 to the positive and negative electrodes.

For high reliability, complete elimination of wire bonds is desirable. Furthermore, the wire bonding adds costs and manufacturing time.

According to the present invention, a light-emitting diode assembly incorporates a power shunting element to protect against damage from electrical overstress, such as from electrostatic discharge (ESD). The power shunting element is coupled in parallel to the LED within the LED lens assembly itself and protects the LED by diverting electrical current from the LED when a certain voltage across the LED is exceeded.

LED assemblies of the present invention employ direct bonding of the electrical contacts of the LED and the power shunting element to the electrodes of the LED assembly, rather than incorporating wire bonds or submount chips. In one embodiment, both the LED and the power shunting element are flip-chips having terminals directly bonded to the positive and negative electrodes. A lens material may be formed to encapsulate the LED. The power shunting element may optionally be encapsulated by the lens material.

Thus, the present invention improves reliability, simplifies manufacturing, and reduces manufacturing costs.
Fig. 1 is side view of a first embodiment of a light-emitting diode assembly including a power shunting element, as described in U.S. Patent No. 5,914,501;
Fig. 2 is side view of a second embodiment of a light-emitting diode assembly including a power shunting element, as described in U.S. Patent No. 5,914,501;
Fig. 3 is a top view of a light-emitting diode package including a power shunting element arranged according to a first embodiment of the present invention;
Fig. 4 is a side view of the light-emitting diode package illustrated in Fig. 3; and
Fig. 5 is a schematic diagram of the light-emitting diode and power shunting element according to one embodiment of the present invention.

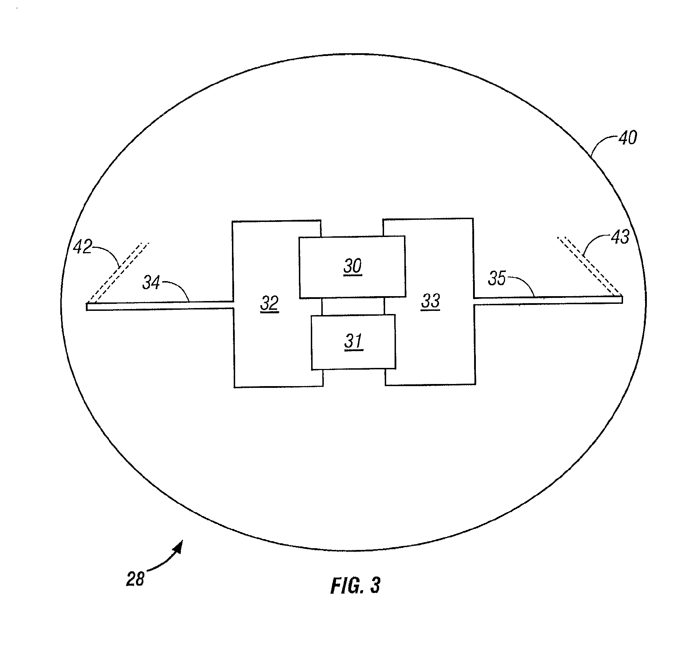

Figure 3 is a top view of a light-emitting diode package 28 including a light-emitting diode (LED) 30 and a power shunting element 31 arranged according to a first embodiment of the present invention.

The LED 30 and the power shunting element 31 are flip-chips, having terminals on one surface. These terminals are directly bonded to pads 32 and 33 of the respective positive electrode 34 and negative electrode 35. The use of flip-chip bonding of both the LED 30 and the power shunting element 31 allows for the complete elimination of wire bonds from the assembly. The bonding may be by ultrasonic bonding, adhesive bonding, or soldering.

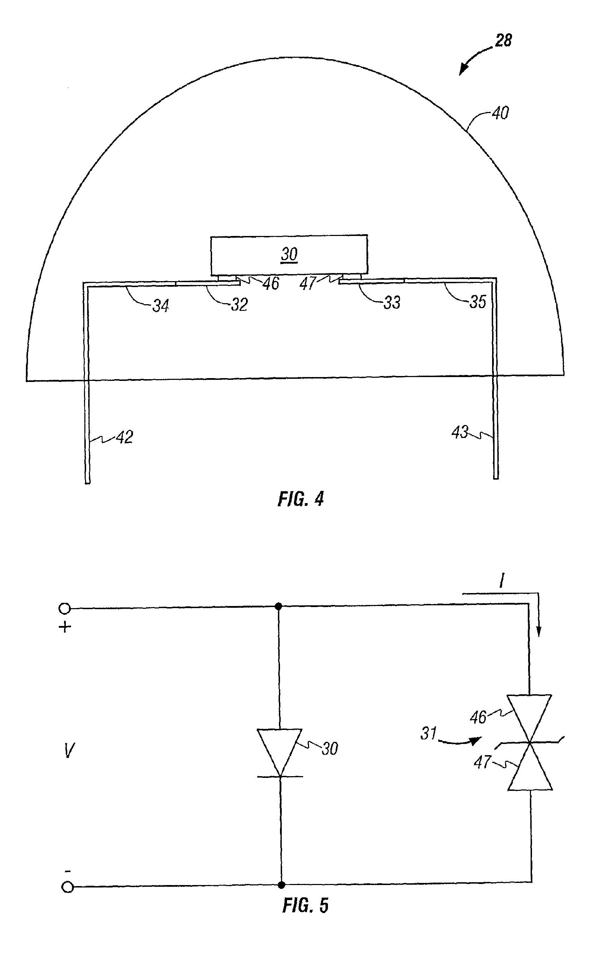

One embodiment of a flip-chip LED that may be used in the present invention is described in U.S. application serial no. 09/469,657, filed December 22, 1999, entitled III-Nitride Light-Emitting Device With Increased Light Generating Capability, by Michael Krames, Daniel Steigerwald, and others, assigned to the present assignee and incorporated by reference. Such a flip-chip LED includes a transparent substrate on which various active layers are grown or deposited. The electrical contacts are formed on the grown or deposited layers to electrically contact n and p-type layers of the LED. The LED is then mounted such that the substrate is the primary window for the light emission. In Fig. 4, the flip-chip substrate is facing upward.

A lens 40 encapsulates the LED 30, power shunting element 31, and electrodes 34/35, with extensions 42 and 43 of the electrodes 34 and 35, respectively, protruding from the lens 40 downward from the plane of the page to a circuit board or other apparatus. The lens 40 may be a high index epoxy or other material.

Figure 4 is a side view of the LED package 28 of Figure 3. In Figure 4, the power shunting element is located behind the LED 30 and is obscured from view. The LED 30 terminal 46 is directly bonded to the positive electrode 34. The LED 30 terminal 47 is directly bonded to the negative electrode 35. The power shunting element has similar terminals directly bonded to the positive electrode 34 and negative electrode 35.

By not providing the power shunting element 31 as a submount, in contrast to Fig. 2, the heat generated by the LED can be directly extracted by the metal electrodes 34 and 35 serving as heat sinks.

Figure 5 is an electrical schematic diagram of the LED 30 and the power shunting element 31 in one embodiment of the present invention. When the voltage applied to the LED 30 exceeds a predetermined threshold voltage, the back-to-back zener diodes 46 and 47 clamp the voltage across the LED 30 to a predetermined voltage and divert current away from the LED 30. Thus, the power shunting element 31 protects the LED from electrical overstress, such as that produced by electrostatic discharge. The power shunting element may be any transient voltage suppressor diode.

In another embodiment, the power shunting element 31 is located outside the lens for increased optical efficiency.

While particular embodiments of the present invention have been shown and described, it will be obvious to those skilled in the art that changes and modifications may be made without departing from this invention in its broader aspects and, therefore, the appended claims are to encompass within their scope all such changes and modifications as fall within the true spirit and scope of this invention.

## Claims

1. A light-emitting diode package, comprising:
- a positive electrode;
- a negative electrode;
- a light-emitting diode having a first electrical contact directly bonded to said positive electrode and a second electrical contact directly bonded to said negative electrode; and
- a power shunting element having a third electrical contact directly bonded to the positive electrode and a fourth electrical contact directly bonded to the negative electrode, said power shunting element shunting electrical current from the light-emitting diode when a voltage applied across the light-emitting diode exceeds a predefined threshold voltage.

2. The package of claim 1 wherein said diode and power shunting element are flip-chips, wherein said first and third electrical contacts are flip-chip bonded to the positive electrode, and wherein said second and fourth electrical contacts are flip-chip bonded to the negative electrode.

3. The package of claim 1 wherein the power shunting element includes a back-to-back zener diode configuration.

4. The package of claim 1 wherein the power shunting element includes a transient voltage suppressor.

5. The package of claim 1 further comprising a lens encapsulating said diode and said power shunting element.

6. The package of claim 5 wherein said lens is epoxy.

7. The package of claim 5 wherein said diode and power shunting elements are flip-chips, wherein said first and third electrical contacts are flip-chip bonded to the positive electrode, and wherein said second and fourth electrical contacts are flip-chip bonded to the negative electrode.

8. The package of claim 5 wherein the power shunting element includes a back-to-back zener diode configuration.

9. A method for manufacturing a light-emitting diode package comprising:
- directly bonding a first terminal of a light-emitting diode to a positive electrode and directly bonding a second terminal of said light emitting diode to a negative electrode; and
- directly bonding a third terminal of a power shunting element to the positive electrode and directly bonding a fourth terminal of said power shunting element to the negative electrode, said power shunting element for shunting electrical current from the light-emitting diode when a voltage applied across the light-emitting diode exceeds a predefined threshold voltage.

10. The method of claim 9 further comprising encapsulating said diode, said power shunting element, said positive electrode, and said negative electrode with a material to form a lens.

11. The method of claim 9 wherein said diode and power shunting element are flip-chips, and said steps of directly bonding comprise flip-chip bonding said first and third electrical contacts to the positive electrode, and flip-chip bonding said second and fourth electrical contacts to the negative electrode.

12. The method of claim 9 wherein the power shunting element includes a back-to-back zener diode configuration.
